# EUROPEAN PATENT SPECIFICATION

(11) **EP 4 072 253 B1**
(45) Date of publication and mention of the grant of the patent: **19.06.2024**
(21) Application number: 20904381.9
(22) Date of filing: 23.12.2020
(51) Int. Cl.: H05K 5/02, H05K 7/14, H02B 13/025, H01H 9/04

(54) **HOUSING FOR ELECTRONIC APPARATUS AND ELECTRONIC APPARATUS**
GEHÄUSE FÜR EIN ELEKTRONISCHES GERÄT UND ELEKTRONISCHES GERÄT
BOÎTIER POUR APPAREIL ÉLECTRONIQUE ET APPAREIL ÉLECTRONIQUE

(30) Priority: 23.12.2019 CN 201922352551 U
(43) Date of publication of application: 12.10.2022
(73) Proprietor: Huawei Digital Power Technologies Co., Ltd., Shenzhen, Guangdong 518043 (CN)
(72) Inventor: LIANG, Chengchen, Shenzhen, Guangdong 518129 (CN); YANG, Yanxiong, Shenzhen, Guangdong 518129 (CN); WANG, Xun, Shenzhen, Guangdong 518129 (CN); ZHANG, Yanzhong, Shenzhen, Guangdong 518129 (CN)
(74) Representative: Maiwald GmbH
(86) International application number: PCT/CN2020/138697
(87) International publication number: WO 2021/129684

(56) References cited:
- CN-A- 105 848 439
- CN-U- 205 681 718
- CN-U- 205 681 718
- CN-U- 212 163 874
- JP-A- 2006 108 257
- US-A1- 2015 334 856
- US-A1- 2019 281 722

## Description

This application claims priority to Chinese Patent Application No. 201922352551.5, filed with the China National Intellectual Property Administration on December 23, 2019 and entitled "Electronic Device Housing and Electronic Device".

### TECHNICAL FIELD

This application relates to the field of electronic device technologies, and in particular, to an electronic device housing and an electronic device.

### BACKGROUND

An electronic device is inseparable from people's life, and the electronic device generally includes a housing and various electronic components disposed in the housing. When working, the electronic component generally needs to be powered on, and the electronic component itself generates heat. The electronic device is under a risk that a short circuit of a current occurs, or the electronic component catches fire, and even an explosion occurs. For some specific high-power electronic devices, for example, a power distribution box, the explosion is more likely to occur. Therefore, a housing of such an electronic device needs to have an explosion-proof function, to avoid damage to a person or another surrounding device caused by partial tearing and explosion (a cover plate is blown away) of the housing during the explosion.

Currently, an explosion-proof method for an electronic device housing is to increase a thickness of the housing and increase a quantity of fastening screws, to isolate explosion impact. There is still another manner of instant pressure relief. The housing may be a sheet metal part, including a movable plate, where the movable plate is installed on a base of the housing by using a rotating shaft. When an explosion occurs inside the housing, the movable plate may rotate around the rotating shaft due to impact, so that the explosion may be relieved at the rotating plate, and a case in which a cover plate is blown away does not occur.

However, a housing whose thickness is increased uses a large quantity of materials. This greatly increases a weight of the entire electronic device, increases costs, and is difficult to install and operate. In a manner of disposing the movable plate and the rotating shaft, a structure is complex, costs are increased, and manufacturing is difficult.
JP 2006 108257 A describes a sealed container that comprises an accommodation part opened at an upper opening and capable of placing articles over the entire region on a bottom surface formed into a substantially rectangular shape, an intervening member disposed over the entire periphery of an external peripheral edge of the opening of the accommodation part, a first cover in contact with the intervening member for covering the opening of the accommodation part, and a second cover fixedly disposed on the accommodation part for energizing the first cover toward the side of the opening of the accommodation part. US 2019/281722 discloses an electronic device housing according to the preamble of claim 1.

### SUMMARY

Embodiments of this application provide an electronic device housing and an electronic device. On a premise that an explosion may be instantly relieved, a structure of the electronic device housing is simple, production and manufacturing are convenient, and costs are low.

To achieve the foregoing objectives, embodiments of this application use the following technical solutions. The invention is set out in the appended claims.

According to a first aspect, an embodiment of this application provides an electronic device housing, including: a box body, where at least one side surface of the box body includes an opening, a cover plate, where the cover plate is fixed at the opening of the box body, and a fastener, where the fastener is a plurality of fasteners, the cover plate is crimped at the opening of the box body by using the plurality of fasteners, and in the plurality of fasteners, a crimping area between at least one fastener and the cover plate is less than a crimping area between another fastener and the cover plate.

According to the electronic device housing in this embodiment of this application, the cover plate is fixed at the opening of the box body by using the plurality of fasteners. In the plurality of fasteners, the crimping area between at least one fastener and the cover plate is less than the crimping area between another fastener and the cover plate. A smaller crimping area indicates lower tensile strength. Therefore, tensile strength of the plurality of fasteners is inconsistent. In this way, when an explosion occurs inside the electronic device housing, a fastener having a smaller crimping area with the cover plate may be impacted and partially opened due to lower tensile strength at the fastener, so that an instant explosion relief opening is formed at the fastener, to relieve impact of the explosion without causing damage to a person or another surrounding device. In addition, an objective of explosion relief may be achieved only through fine adjustment of a structure at the fastener, and a complex structure such as a housing with a large thickness or a rotating shaft does not need to be disposed. Therefore, a structure of the electronic device housing is simple, production and manufacturing are convenient, and costs are low.

At least three through holes are disposed on the cover plate and the box body in alignment, and the plurality of fasteners crimp and fasten the cover plate and the box body by using the at least three through holes. The cover plate is fixed to the box body by using the plurality of fasteners. The fasteners fasten at least two components, and need to correspondingly pass through mounting holes. Therefore, the at least three through holes are disposed on the cover plate and the box body in alignment, and the plurality of fasteners crimp and fasten the cover plate and the box body by using the at least three through holes.

Hole diameters of the at least three through holes gradually decrease from one side to the other opposite side of the cover plate. When the explosion occurs inside the electronic device housing, the position with the lowest tensile strength is punched away, and the pressure relief opening is further opened, to relieve the explosion. A position of the pressure relief opening directly affects a formation form of the pressure relief opening during the explosion. For example, when the pressure relief opening is on a side edge of the cover plate, the side edge of the cover plate folds, and when the pressure relief opening is in the middle of the cover plate, the middle of the cover plate bulges.

In a second optional implementation of the first aspect, the plurality of fasteners are a plurality of screws, and one end of the plurality of screws passes through the plurality of through holes and is fastened to the box body. The fastener may be a combination of any one or more of a bolt, a stud, a screw, a nut, and a tapping screw.

In a third optional implementation of the first aspect, in the plurality of screws, a diameter of at least one screw is less than a diameter of another screw. In a case in which the fastener is the plurality of screws and a material of the screw is determined, a smaller diameter of a screw indicates lower tensile strength of the screw. Therefore, in the plurality of screws, the diameter of at least one screw is less than the diameter of the another screw, and when the explosion occurs inside the electronic device housing, a position near a screw with a smallest diameter is installed on the cover plate is punched away, and the pressure relief opening is formed, to quickly relieve the explosion.

In a fourth optional implementation of the first aspect, diameters of the plurality of screws gradually increase from one side to the other opposite side of the cover plate. A difference in tensile strength at different positions of the cover plate is achieved by using a difference in diameters of the screws. For example, the tensile strength gradually increases from one side to the other opposite side of the cover plate, so that the air flow direction of the explosion relief opening may be controlled, and devices that cannot be impacted may be avoided in a targeted manner.

In a fifth optional implementation of the first aspect, a washer is disposed between a nut of at least one of the plurality of screws and the cover plate, and a diameter of an outer ring of the washer is greater than a diameter of the nut of the screw. Tensile strength of a corresponding position may be changed by changing the crimping area between the cover plate and the fastener. Alternatively, the crimping area between the cover plate and the faster may be changed by adding another structure. For example, the washer is disposed. In this case, because the diameter of the outer ring of the washer is greater than the diameter of the nut of the screw, compared with a position near a screw on which no washer is disposed, the washer provides a larger crimping area for a position near a screw on which a washer is disposed on the cover plate, so that tensile strength may be increased. Therefore, the washer may be disposed at a position on which tensile strength needs to be increased. In addition, the washer may fasten the fastener more reliably.

In a sixth optional implementation of the first aspect, in the plurality of screws, a washer is disposed between a nut of each screw and the cover plate, and a diameter of an outer ring of the washer is greater than a diameter of the nut of the screw. In addition, a contact area between the washer of at least one of the screws and the cover plate is smaller than a contact panel of a contact area between a washer of another screw and the cover plate. When the washer is disposed between the nut of each screw and the cover plate, a diameter of the washer determines a size of a crimping area with the cover plate. Therefore, washers of different specifications may be selected to provide different crimping areas, to achieve a difference in tensile strength at different positions.

In a seventh optional implementation of the first aspect, contact areas between the cover plate and the plurality of washers gradually increase from one side to the other opposite side of the cover plate. Crimping areas at different positions are provided by using a plurality of washers of different specifications. The crimping areas may be from one side to the other opposite side of the cover plate, so that the air flow direction of the explosion relief opening may be controlled, and devices that cannot be impacted may be avoided in a targeted manner. Certainly, from one side to the other opposite side of the cover plate may be from the upper side to the lower side of the cover plate, from the lower side to the upper side of the cover plate, from the left side to the right side of the cover plate, or from the right side to the left side of the cover plate.

In a eighth optional implementation of the first aspect, at least three screws are sequentially disposed from one side to the other opposite side of the cover plate, and a diameter of a washer of a screw located in a middle position in the three screws is less than diameters of washers of screws located on two sides. When the pressure relief opening is in the middle of the cover plate, the middle of the cover plate bulges when the explosion occurs. This rarely causes tearing of the cover plate and is safer.

In a ninth optional implementation of the first aspect, a foldable structure exists between a fastener having a smallest crimping area with the cover plate and another fastener. When the explosion occurs inside the electronic device housing, the fastener having the smallest crimping area with the cover plate is punched away, and the pressure relief opening is further formed, to relieve the explosion. However, the another fastener is not punched away. Therefore, the pressure relief opening is formed by bending or tearing when deformation occurs between the fastener with the smallest crimping area with the cover plate and the another fastener. Therefore, to facilitate formation of the pressure relief opening, the foldable structure is disposed at a pre-bending position.

In a tenth optional implementation of the first aspect, the foldable structure is a groove provided between the fastener having the smallest crimping area with the cover plate and the another fastener. In an implementation of the foldable structure, the groove is provided on a side edge or in a middle part, so that strength of the groove is reduced and the groove is easy to bend.

According to a second aspect, an embodiment of this application provides an electronic device, including the electronic device housing according to any one of the first aspect.

The electronic device provided in this embodiment of this application includes the electronic device housing according to any one of the first aspect. Therefore, on a premise that the explosion may be instantly relieved, a structure of the electronic device is a simple, production and manufacturing are convenient, and costs are low.

### BRIEF DESCRIPTION OF DRAWINGS

FIG. 1 is a schematic diagram of a breakdown structure of an electronic device housing according to an embodiment of this application;
FIG. 2 is a schematic diagram of a structure of deformation of a cover plate during explosion relief of an electronic device housing according to an embodiment of this application;
FIG. 3 is a schematic diagram of a structure of a cover plate of an electronic device housing according to an embodiment of this application;
FIG. 4 is a first schematic diagram of a structure of a disposing manner of a through hole of a cover plate of an electronic device housing according to an embodiment of this application;
FIG. 5 is a second schematic diagram of a structure of a disposing manner of a through hole of a cover plate of an electronic device housing according to an embodiment of this application;
FIG. 6 is a third schematic diagram of a structure of a disposing manner of a through hole of a cover plate of an electronic device housing according to an embodiment not encompassed by the wording of the appended set of claims but considered as useful for understanding the invention; and
FIG. 7 is a schematic diagram of a three-dimensional structure of an electronic device housing according to an embodiment of this application.

### Reference numerals:

1: box body; 11: opening; 2: cover plate; 21: plug part; 3: fastener; 31: screw; 4: through hole; 41: first through hole; 42: second through hole; 43: third through hole; and 5: groove.

### DESCRIPTION OF EMBODIMENTS

Generally, an electronic device includes a housing, and various electronic components are disposed in the housing. The electronic components work after being powered on, consume electric energy to work, and generate heat, especially in an airtight housing of the electronic device. This may even cause an explosion. To prevent the electronic device housing from being torn and flying out due to the explosion, causing a phenomenon that a cover plate is blown away and causing damage to a person or another surrounding device, the following manners may be used. First, a thickness of the electronic device housing is increased, to increase strength of the housing, so that the electronic device housing is not easily exploded. Second, at least one side of the electronic device housing is provided with a side panel that is connected in a hinged manner, and when the explosion occurs, the side panel rotates around a hinge connection to open an explosion relief opening.

Explosion relief refers to timely relieve an explosion impact generated inside an airtight space. In the first manner, a weight of the entire electronic device is significantly increased, a large quantity of materials are used, an operation is inconvenient, and costs are high. In the second manner, a disposing manner of hinge is complex, assembly is difficult, and costs are high.

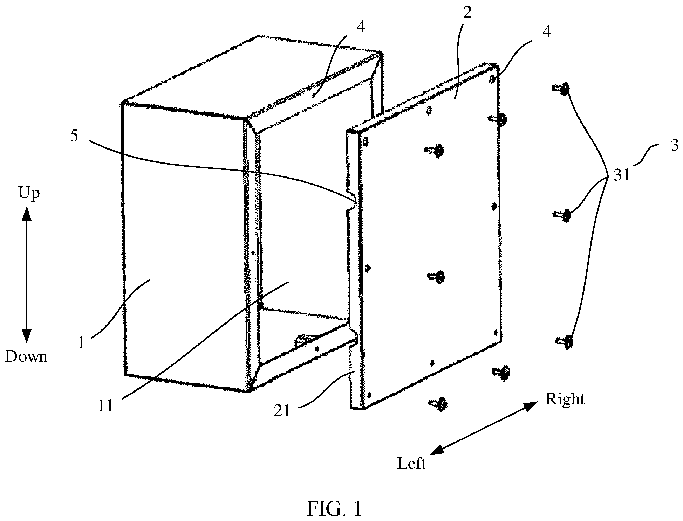

An embodiment of this application provides an electronic device, including an electronic device housing. As shown in FIG. 1, the electronic device housing includes: a box body 1, where at least one side surface of the box body 1 includes an opening 11, a cover plate 2, where the cover plate 2 is fixed at the opening 11 of the box body 1, and a fastener 3, where the fastener 3 is a plurality of fasteners 3, the cover plate 2 is crimped at the opening of the box body 1 by using the plurality of fasteners 3, and in the plurality of fasteners 3, a crimping area between at least one fastener 3 and the cover plate 2 is less than a crimping area between another fastener 3 and the cover plate 2.

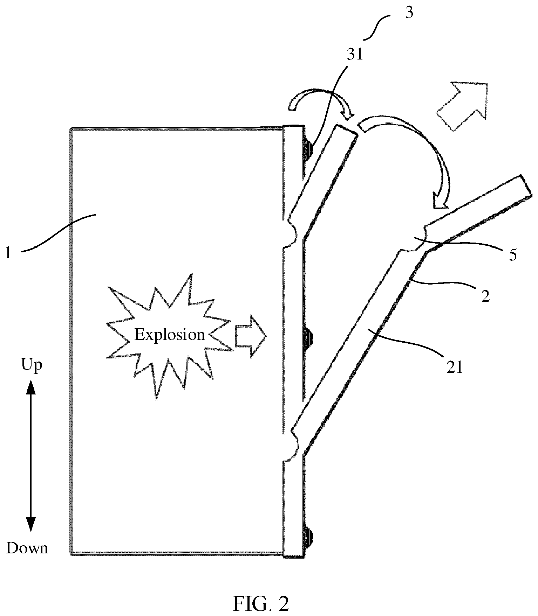

According to the electronic device in this embodiment of this application, in the electronic device housing included in the electronic device, as shown in FIG. 1, the cover plate 2 is fixed at the opening 11 of the box body 1 by using the plurality of fasteners 3. In the plurality of fasteners 3, the crimping area between at least one fastener 3 and the cover plate 2 is less than the crimping area between the another fastener 3 and the cover plate 2. A smaller crimping area indicates lower tensile strength. Therefore, tensile strength of the plurality of fasteners 3 is inconsistent. Refer to FIG. 2. When the explosion occurs inside the electronic device housing, the fastener 3 having a smaller crimping area with the cover plate 2 may be impacted and partially opened due to lower tensile strength at the fastener 3, so that the instant explosion relief opening is formed at the fastener 3, to relieve impact of the explosion without causing damage to a person or another surrounding device. In addition, an objective of explosion relief may be achieved only through fine adjustment of a structure at the fastener 3, and a complex structure such as a housing with a large thickness or a rotating shaft does not need to be disposed. Therefore, a structure of the electronic device housing is simple, production and manufacturing are convenient, and costs are low.

It should be noted that the electronic device housing of the electronic device in this embodiment of this application may achieve the explosion relief objective without changing or with slightly changing a thickness of a base material of a chassis and a quantity of fasteners 3. In addition, the electronic device housing has low costs, a light-weight chassis, and a simple structure without complex design. In addition, the electronic device in this embodiment of this application may be any electronic device provided with a housing, for example, a power distribution box, a desktop computer, a terminal communication device, or the like.

An embodiment of this application further provides an electronic device housing. As shown in FIG. 1, the electronic device housing includes the box body 1, where at least one side surface of the box 1 includes the opening 11, the cover plate 2, where the cover plate 2 is fixed at the opening 11 of the box body 1, and the fastener 3, where the fastener 3 is the plurality of fasteners 3, the cover plate 2 is crimped at the opening 11 of the box body 1 by using the plurality of fasteners 3, and in the plurality of fasteners 3, the crimping area between at least one fastener 3 and the cover plate 2 is less than the crimping area between the another fastener 3 and the cover plate 2.

According to the electronic device housing in this embodiment of this application, as shown in FIG. 1, the cover plate 2 is fixed at the opening 11 of the box body 1 by using the plurality of fasteners 3. In the plurality of fasteners 3, the crimping area between at least one fastener 3 and the cover plate 2 is less than the crimping area between the another fastener 3 and the cover plate 2. A smaller crimping area indicates lower tensile strength. Therefore, the tensile strength of the plurality of fasteners 3 is inconsistent. Refer to FIG 2. When the explosion occurs inside the electronic device housing, the fastener 3 having a smaller crimping area with the cover plate 2 may be impacted first and partially opened due to lower tensile strength at the fastener 3, so that the instant explosion relief opening is formed at the fastener 3, to relieve impact of the explosion without causing damage to a person or another surrounding device. In addition, an objective of explosion relief may be achieved only through fine adjustment of a structure at the fastener 3, and a complex structure such as a housing with a large thickness or a rotating shaft does not need to be disposed. Therefore, a structure of the electronic device housing is simple, production and manufacturing are convenient, and costs are low.

In the plurality of fasteners 3, the crimping area between at least one fastener 3 and the cover plate 2 is less than the crimping area between the another fastener 3 and the cover plate 2, so that the tensile strength of the plurality of fasteners 3 of the cover plate 2 may be different. In the plurality of fasteners 3, it may be that the crimping area between only one fastener 3 and the cover plate 2 is smaller than the crimping area between the another fastener 3 and the cover plate 2. Alternatively, it may be that crimping areas between the plurality of fasteners 3 and the cover plate 2 may be smaller than the crimping area between the another fastener 3 and the cover plate 2, where in the plurality of fasteners 3 having smaller crimping areas with the cover plate 2, the crimping areas may be the same or different. Alternatively, crimping areas between all the fasteners 3 and the cover plate 2 are different.

In addition, it should be noted that the crimping areas between the plurality of fasteners 3 and the cover plate 2 are different, and arrangement and distribution manners may also be implemented in a plurality of manners. For example, the crimping areas between the plurality of fasteners 3 and the cover plate 2 increase from one side to the other opposite side of the cover plate 2, the crimping areas between the plurality of fasteners 3 and the cover plate 2 increase from a middle part to an outer edge of the cover plate 2, or the crimping areas between the plurality of fasteners 3 and the cover plate 2 increase from the outer edge to the middle part of the cover plate 2. In a solution in which the crimping areas between the plurality of fasteners 3 and the cover plate 2 increase from one side to the other opposite side of the cover plate 2, when the explosion occurs, a side edge of the cover plate 2 folds, and the pressure relief opening is located at the side edge of the cover plate 2. In this way, the air flow direction of the explosion relief opening may be controlled, and devices that cannot be impacted may be avoided in a targeted manner. In a solution in which the crimping areas between the plurality of fasteners 3 and the cover plate 2 increase from the middle part to the outer edge of the cover plate 2 (or from the outer edge to the middle part of the cover plate 2), when the explosion occurs, the middle part of the cover plate 2 bulges, and the pressure relief opening is located in the middle of the cover plate 2. In this way, the cover plate 2 is rarely torn, and is safer.

The cover plate 2 is fixed to the box body 1 by using the plurality of fasteners 3. The fasteners 3 fasten at least two components, and need to correspondingly pass through mounting holes. Therefore, as shown in FIG. 1, a plurality of through holes 4 are disposed on the cover plate 2 and the box body 1 in alignment, the plurality of fasteners 3 crimp and fasten the cover plate 2 and the box body 1 by using the plurality of through holes 4.

After the through hole 4 is disposed, the fastener 3 passes through the through hole 4, and an edge of the through hole 4 is crimped by a nut or a stud head of the fastener 3. In a case in which strength of the fastener 3 is determined and sizes of the nut or the stud head are the same, a larger hole diameter of the through hole 4 indicates that fewer positions on the cover plate 2 are crimped by the fastener 3, and relative tensile strength is lower. Therefore, because in the plurality of through holes 4, a hole diameter of at least one through hole 4 is greater than a hole diameter of another through hole 4, that is, tensile strength of the at least one through hole 4 is lower than tensile strength of the another through hole 4, when the explosion occurs in the electronic device housing, the position with the lowest tensile strength is punched away, the pressure relief opening is further opened, and the explosion may be instantly relieved. This does not cause a cover plate to be blown away or damage to a person or another device.

When the explosion occurs inside the electronic device housing, the position with the lowest tensile strength is punched away, and the pressure relief opening is further opened, to relieve the explosion. A position of the pressure relief opening directly affects a formation form of the pressure relief opening during the explosion. For example, refer to FIG. 2. When the pressure relief opening is on a side edge of the cover plate 2, the side edge of the cover plate 2 folds, and when the pressure relief opening is in the middle of the cover plate 2, the middle of the cover plate 2 bulges. In other words, hole diameters of the plurality of through holes 4 gradually decrease from one side to the other opposite side of the cover plate 2.

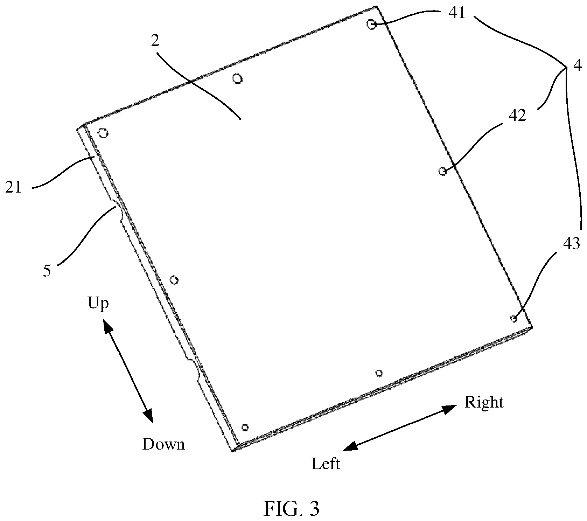

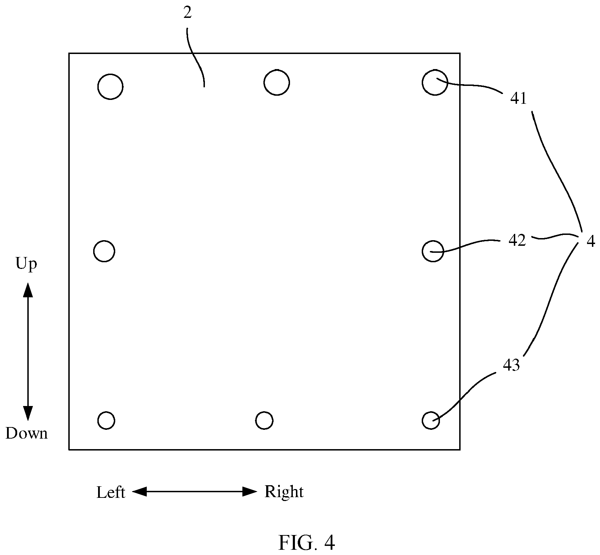

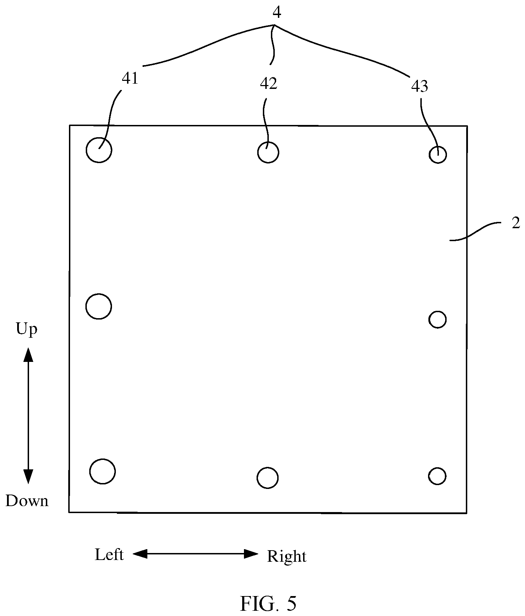

In some embodiments, the hole diameters of the plurality of through holes 4 may decrease from an upper side to a lower side of the cover plate 2, from the lower side to the upper side of the cover plate 2, from a left side to a right side of the cover plate 2, or from the right side to the left side of the cover plate 2. In other words, provided that the pressure relief opening is on a side edge of the cover plate 2, when the explosion occurs, the side edge of the cover plate 2 needs to be folded. In this way, the air flow direction of the explosion relief opening may be controlled, and devices that cannot be impacted may be avoided in a targeted manner. For example, refer to FIG. 3 and FIG. 4. The hole diameters of the plurality of through holes 4 gradually decrease from the upper side to the lower side of the cover plate 2 (hole diameters of a first through hole 41, a second through hole 42, and a third through hole 43 gradually decrease). Refer to FIG. 5. The hole diameters of the plurality of through holes 4 gradually decrease from the left side to the right side of the cover plate 2 (the hole diameters of the first through hole 41, the second through hole 42, and the third through hole 43 decrease sequentially).

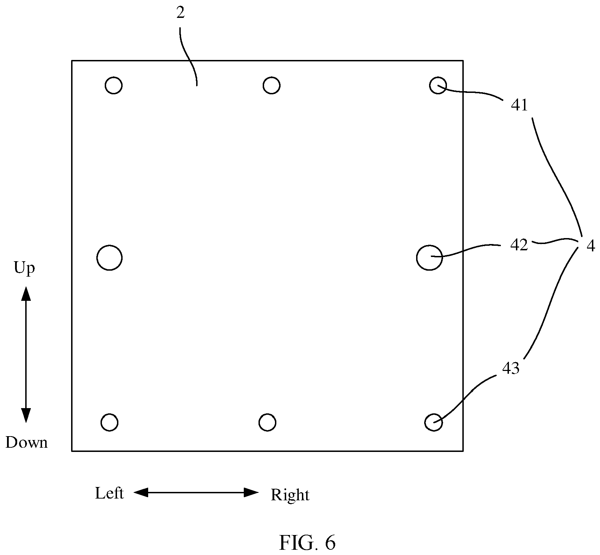

In some embodiments, at least three through holes 4 are sequentially disposed from one side to the other opposite side of the cover plate 2, and a hole diameter of the through hole 4 located in a middle position is greater than hole diameters of the through holes 4 located on two sides. In this way, when the pressure relief opening is in the middle of the cover plate 2, the middle of the cover plate 2 bulges when the explosion occurs. This rarely causes tearing of the cover plate 2 and is safer. For example, as shown in FIG. 6, three through holes 4 (which are respectively the first through hole 41, the second through hole 42, and the third through hole 43) are sequentially disposed at an edge of the cover plate 2 from the upper side to the lower side, a hole diameter of the second through hole 42 located in a middle position is greater than hole diameters of the first through hole 41 and the third through hole 43 located on two sides.

The fastener 3 may be a combination of any one or more of a bolt, a stud, a screw, a nut, and a tapping screw. Refer to FIG. 1. The plurality of fasteners 3 are a plurality of screws 31, and one end of the plurality of screws 31 passes through the plurality of through holes 4 and is fastened to the box body 1.

In a case in which the fastener 3 is the plurality of screws 31 and a material of the screw 31 is determined, a smaller diameter of the screw 31 indicates lower tensile strength of the screw 31. Therefore, in the plurality of screws 31, a diameter of at least one screw 31 is less than a diameter of another screw 31, and when the explosion occurs inside the electronic device housing, a position near the screw 31 with a smallest diameter is installed on the cover plate 2 is punched away, and the pressure relief opening is formed, to quickly relieve the explosion.

A difference in tensile strength at different positions of the cover plate 2 is achieved by using a difference in diameters of the screws 31. For example, the tensile strength gradually increases from one side to the other opposite side of the cover plate 2, so that the air flow direction of the explosion relief opening may be controlled, and devices that cannot be impacted may be avoided in a targeted manner.

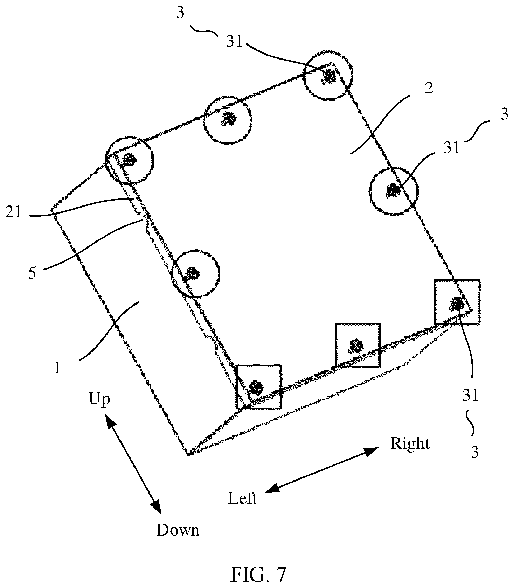

The diameters of the plurality of screws 31 may gradually increase from the upper side to the lower side of the cover plate 2, from the lower side to the upper side of the cover plate 2, from the left side to the right side of the cover plate 2, or from the right side to the left side of the cover plate 2. From the upper side to the lower side of the cover plate 2, strength of the fastener 3 gradually increases from top to bottom. For example, refer to FIG. 7. The fastener 3 marked in a circle range is the fastener 3 with low strength, and the fastener marked in a box range is the fastener 3 with high strength.

In addition, it should be noted that, achieving a tensile strength difference at different positions of the cover plate 2 by using a difference in the diameters of the screws 31 is only an implementation. The difference in the diameters of the screws 31 is used to make strength of the plurality of screws 31 different, to form different tensile strength differences. Alternatively, another manner may be used. For example, a material of low strength, such as plastic, may be selected as a material of the screw 31, or a material of high strength, such as metal, may be selected as a material of the screw 31. In this way, different tensile strength differences at different positions of the cover plate 2 may also be achieved.

At least three screws 31 are sequentially disposed from one side to the other opposite side of the cover plate 2, and a diameter of a screw 31 in a middle position in the three screws 31 is less than diameters of screws 31 on two sides. A difference in tensile strength at different positions of the cover plate 2 is achieved by using a difference in the diameters of the screws 31, for example, tensile strength gradually increases from a middle part to two sides of the cover plate 2. When the pressure relief opening is in the middle of the cover plate 2, the middle of the cover plate 2 bulges when the explosion occurs. This rarely causes tearing of the cover plate 2 and is safer.

Tensile strength of a corresponding position may be changed by changing the crimping area between the cover plate 2 and the fastener 3. Alternatively, the crimping area may be changed by adding another structure between the cover plate 2 and the fastener 3. For example, in the plurality of screws 31, a washer is disposed between a nut of at least one screw 31 and the cover plate 2, and a diameter of an outer ring of the washer is greater than a diameter of the nut of the screw 31. Because the diameter of the outer ring of the washer is greater than the diameter of the nut of the screw 31, compared with a position near the screw 31 on which no washer is disposed, the washer provides a larger crimping area for a position near the screw 31 on which a washer is disposed on the cover plate 2, so that tensile strength may be increased. Therefore, the washer may be disposed at a position on which tensile strength needs to be increased. In addition, the washer may fasten the fastener 3 more reliably.

When the washer is disposed between the nut of each screw 31 and the cover plate 2, a diameter of the washer determines a size of a crimping area with the cover plate 2. Therefore, washers of different specifications may be selected to provide different crimping areas, to achieve a difference in tensile strength at different positions. Specifically, in the plurality of screws 31, a washer is disposed between a nut of each screw 31 and the cover plate 2, and a diameter of an outer ring of the washer is greater than a diameter of the nut of the screw 31. In addition, a contact area between the washer of at least one of the screws 31 and the cover plate 2 is smaller than a contact panel of a contact area between a washer of another screw 31 and the cover plate 2.

Crimping areas at different positions are provided by using a plurality of washers of different specifications. The crimping areas between the plurality of washers and the cover plate 2 may gradually increase from one side to the other opposite side of the cover plate 2, so that the air flow direction of the explosion relief opening may be controlled, and devices that cannot be impacted may be avoided in a targeted manner. Certainly, the direction from one side to the other opposite side of the cover plate 2 may be from an upper side to a lower side of the cover plate 2, from a lower side to an upper side of the cover plate 2, from a left side to a right side of the cover plate 2, or from a right side to a left side of the cover plate 2.

In some embodiments, at least three screws 31 are sequentially disposed from one side to the other opposite side of the cover plate 2, and a diameter of a washer of a screw 31 located in a middle position in the three screws is less than diameters of washers of screws 31 located on two sides. When the pressure relief opening is in the middle of the cover plate 2, the middle of the cover plate 2 bulges when the explosion occurs. This rarely causes tearing of the cover plate 2 and is safer.

It should be noted that, in the foregoing embodiment, the hole diameter of the through hole 4, the diameter of the screw 31, disposing the diameter of the washer and diameter of the outer ring of the washer are described, so that the crimping area between the plurality of fasteners 3 and the cover plate 2 may be adjusted. The foregoing implementation is merely an example, other implementations also fall within the protection scope of this application. In addition, a specific manner of the hole diameter of the through hole 4, the diameter of the screw 31, disposing the diameter of the washer and diameter of the outer ring of the washer may be flexibly selected based on an actual requirement, or any one or more embodiments or examples may be combined in a proper manner. In this way, a crimping area of a corresponding position is small and the explosion is easy to relieve.

When the explosion occurs inside the electronic device housing, a fastener 3 having a smallest crimping area with the cover plate 2 is punched away, and the pressure relief opening is formed, to relieve the explosion. However, another fastener 3 is not punched away. Therefore, the pressure relief opening is formed by bending or tearing when deformation occurs between the fastener 3 with the smallest crimping area with the cover plate 2 and the another fastener 3. Therefore, to facilitate formation of the pressure relief opening, a foldable structure is disposed at a pre-bending position. In other words, the foldable structure exists between the fastener 3 having the smallest crimping area with the cover plate 2 and the another fastener 3.

The foldable structure may be implemented in a plurality of manners. For example, refer to FIG. 1 and FIG. 2. The foldable structure is a groove 5 provided between the fastener 3 having the smallest crimping area with the cover plate 2 and the another fastener 3. The groove 5 is provided on a side edge or in a middle part, so that strength of the groove 5 is reduced and the groove 5 is easy to bend.

It should be noted that the groove 5 may have a plurality of shapes, provided that strength of a corresponding position may be reduced. The groove is any one or a combination of a circle, a square, a strip, and a triangle.

For example, the foldable structure may alternatively be an indentation provided between the fastener 3 having the smallest crimping area with the cover plate 2 and the another fastener 3. The indentation is disposed at a corresponding position on the side, and the indentation is easy to bend.

The box body 1 and the cover plate 2 of the electronic device housing in this embodiment of this application may be made of a sheet metal material. In other words, a sheet metal housing is a housing required after the sheet metal is cooled and formed by using a comprehensive cold processing technology. The processing technology includes severing, punching, cutting, compounding, folding, welding, riveting, joining, forming, and the like. Materials are easy to obtain, and manufacturing costs are low.

In some embodiments, as shown in FIG. 1, a side edge of the cover plate 2 is bent towards the box body 1, to form a plug part 21. When the cover plate 2 is fixed to the box body 1, the plug part 21 is inserted into the box body 1. The plug part 21 may guide installation of the limiting cover plate 2 and the box body 1, and increase overall strength of the cover plate 2. In addition, after the plug part 21 is disposed, the groove 5 may be opened at an edge of the plug part 21 to form the foldable structure.

In the description of this specification, the specific features, structures, materials, or characteristics may be combined in a proper manner in any one or more of embodiments or examples.

Finally, it should be noted that the foregoing embodiments are merely intended for describing the technical solutions of this application, but not for limiting the application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. An electronic device housing, comprising:
a box body (1), wherein at least one side surface of the box body (1) comprises an opening (11);
a cover plate (2), wherein the cover plate (2) is fixed at the opening of the box; and
a fastener (3), wherein the fastener (3) is a plurality of fasteners, the cover plate (2) is crimped at the opening of the box body (1) by using the plurality of fasteners, and in the plurality of fasteners, a crimping area between at least one fastener and the cover plate (2) is less than a crimping area between another fastener and the cover plate (2),
wherein at least three through holes (4) are disposed on the cover plate (2) and the box body (1) in alignment, and the plurality of fasteners crimp and fasten the cover plate (2) and the box body (1) by using the at least three through holes (4), **characterized in that**
hole diameters of the at least three through holes (4) gradually decrease from one side to the other opposite side of the cover plate (2).

2. The electronic device housing according to claim 1, wherein the plurality of fasteners are a plurality of screws (31), and one end of the plurality of screws (31) passes through the plurality of through holes and is fastened to the box body (1).

3. The electronic device housing according to claim 2, wherein in the plurality of screws (31), a diameter of at least one screw is less than a diameter of another screw.

4. The electronic device housing according to claim 2 or 3, wherein diameters of the plurality of screws (31) gradually increase from one side to the other opposite side of the cover plate (2).

5. The electronic device housing according to any one of claims 2 to 4, wherein a washer is disposed between a nut of at least one of the plurality of screws and the cover plate (2), and a diameter of an outer ring of the washer is greater than a diameter of the nut of the screw.

6. The electronic device housing according to any one of claims 2 to 4, wherein in the plurality of screws, a washer is disposed between a nut of each screw and the cover plate (2), wherein a diameter of an outer ring of the washer is greater than a diameter of the nut of the screw, and a contact area between the washer of at least one of the screws and the cover plate (2) is smaller than a contact panel of a contact area between a washer of another screw and the cover plate (2).

7. The electronic device housing according to claim 6, wherein a contact area between the cover plate (2) and a plurality of washers gradually increases from one side to the other opposite side of the cover plate (2).

8. The electronic device housing according to claim 6, wherein at least three screws (31) are sequentially disposed from one side to the other opposite side of the cover plate (2), and a diameter of a washer of a screw located in a middle position in the three screws is less than diameters of washers of screws located on two sides.

9. The electronic device housing according to any one of claims 1 to 8, wherein a foldable structure exists between a fastener having a smallest crimping area with the cover plate (2) and another fastener.

10. The electronic device housing according to claim 9, wherein the foldable structure is a groove (5) provided between the fastener having the smallest crimping area with the cover plate (2) and the another fastener.

11. An electronic device, comprising the electronic device housing according to any one of claims 1 to 10.

## Patentansprüche

1. Gehäuse für eine elektronische Vorrichtung, das umfasst:
einen Kastenkörper (1), wobei mindestens eine Seitenoberfläche des Kastenkörpers (1) eine Öffnung (11) umfasst;
eine Abdeckplatte (2), wobei die Abdeckplatte (2) an der Öffnung des Kastens fixiert ist; und
ein Befestigungselement (3), wobei das Befestigungselement (3) eine Vielzahl von Befestigungselementen ist, die Abdeckplatte (2) durch Verwenden der Vielzahl von Befestigungselementen an der Öffnung des Kastenkörpers (1) gecrimpt ist, und in der Vielzahl von Befestigungselementen ein Crimpbereich zwischen mindestens einem Befestigungselement und der Abdeckplatte (2) kleiner als ein Crimpbereich zwischen einem anderen Befestigungselement und der Abdeckplatte (2) ist,
wobei mindestens drei Durchgangslöcher (4) an der Abdeckplatte (2) und dem Kastenkörper (1) in Ausrichtung angeordnet sind und die Vielzahl von Befestigungselementen die Abdeckplatte (2) und den Kastenkörper (1) durch Verwenden der mindestens drei Durchgangslöcher (4) crimpen und befestigen, **dadurch gekennzeichnet, dass**
Lochdurchmesser der mindestens drei Durchgangslöcher (4) von einer Seite zu der anderen gegenüberliegenden Seite der Abdeckplatte (2) allmählich abnehmen.

2. Gehäuse für eine elektronische Vorrichtung nach Anspruch 1, wobei die Vielzahl von Befestigungselementen eine Vielzahl von Schrauben (31) sind und ein Ende der Vielzahl von Schrauben (31) durch die Vielzahl von Durchgangslöcher verläuft und an dem Kastenkörper (1) befestigt ist.

3. Gehäuse für eine elektronische Vorrichtung nach Anspruch 2, wobei in der Vielzahl von Schrauben (31) ein Durchmesser von mindestens einer Schraube kleiner als ein Durchmesser einer anderen Schraube ist.

4. Gehäuse für eine elektronische Vorrichtung nach Anspruch 2 oder 3, wobei Durchmesser der Vielzahl von Schrauben (31) von einer Seite zu der anderen gegenüberliegenden Seite der Abdeckplatte (2) allmählich zunehmen.

5. Gehäuse für eine elektronische Vorrichtung nach einem der Ansprüche 2 bis 4, wobei eine Unterlegscheibe zwischen einer Mutter von mindestens eines von der Vielzahl von Schrauben und der Abdeckplatte (2) angeordnet ist und ein Durchmesser eines Außenrings der Unterlegscheibe größer als ein Durchmesser der Mutter der Schraube ist.

6. Gehäuse für eine elektronische Vorrichtung nach einem der Ansprüche 2 bis 4, wobei in der Vielzahl von Schrauben eine Unterlegscheibe zwischen einer Mutter jeder Schraube und der Abdeckplatte (2) angeordnet ist, wobei ein Durchmesser eines Außenrings der Unterlegscheibe größer als ein Durchmesser der Mutter der Schraube ist und ein Kontaktbereich zwischen der Unterlegscheibe mindestens eines von den Schrauben und der Abdeckplatte (2) kleiner als ein Kontaktfeld eines Kontaktbereichs zwischen einer Unterlegscheibe einer anderen Schraube und der Abdeckplatte (2) ist.

7. Gehäuse für eine elektronische Vorrichtung nach Anspruch 6, wobei ein Kontaktbereich zwischen der Abdeckplatte (2) und einer Vielzahl von Unterlegscheiben von einer Seite zu der anderen gegenüberliegenden Seite der Abdeckplatte (2) allmählich zunimmt.

8. Gehäuse für eine elektronische Vorrichtung nach Anspruch 6, wobei mindestens drei Schrauben (31) von einer Seite zu der anderen gegenüberliegenden Seite der Abdeckplatte (2) nacheinander angeordnet sind, und ein Durchmesser einer Unterlegscheibe einer Schraube, die in einer mittleren Position in den drei Schrauben gelegen ist, kleiner als Durchmesser von Unterlegscheiben von Schrauben ist, die auf zwei Seiten gelegen sind.

9. Gehäuse für eine elektronische Vorrichtung nach einem der Ansprüche 1 bis 8, wobei eine faltbare Struktur zwischen einem Befestigungselement, das einen kleinsten Crimpbereich mit der Abdeckplatte (2) aufweist, und einem anderen Befestigungselement besteht.

10. Gehäuse für eine elektronische Vorrichtung nach Anspruch 9, wobei die faltbare Struktur eine Nut (5) ist, die zwischen dem Befestigungselement, das den kleinsten Crimpbereich mit der Abdeckplatte (2) aufweist, und dem anderen Befestigungselement bereitgestellt ist.

11. Elektronische Vorrichtung, die das Gehäuse für eine elektronische Vorrichtung nach einem der Ansprüche 1 bis 10 umfasst.

## Revendications

1. Boitier de dispositif électronique, comprenant :
un corps de boîte (1), dans lequel au moins une surface latérale du corps de boîte (1) comprend une ouverture (11) ;
une plaque de recouvrement (2), dans lequel la plaque de recouvrement (2) est fixée au niveau de l'ouverture du boîtier ; et
une fixation (3), dans lequel la fixation (3) est une pluralité de fixations, la plaque de recouvrement (2) est sertie au niveau de l'ouverture du corps de boîte (1) en utilisant la pluralité de fixations, et dans la pluralité de fixations, une zone de sertissage entre au moins une fixation et la plaque de recouvrement (2) est inférieure à une zone de sertissage entre une autre fixation et la plaque de recouvrement (2),
dans lequel au moins trois trous traversants (4) sont disposés sur la plaque de recouvrement (2) et le corps de boîte (1) en alignement, et la pluralité de fixations sertissent et fixent la plaque de recouvrement (2) et le corps de boîte (1) en utilisant les au moins trois trous traversants (4), **caractérisé en ce que**
des diamètres de trous des au moins trois trous traversants (4) diminuent progressivement d'un côté à l'autre côté opposé de la plaque de recouvrement (2).

2. Boîtier de dispositif électronique selon la revendication 1, dans lequel la pluralité de fixations sont une pluralité de vis (31), et une extrémité de la pluralité de vis (31) traverse la pluralité de trous traversants et est fixée au corps de boîte (1).

3. Boîtier de dispositif électronique selon la revendication 2, dans lequel dans la pluralité de vis (31), un diamètre d'au moins une vis est inférieur à un diamètre d'une autre vis.

4. Boîtier de dispositif électronique selon la revendication 2 ou 3, dans lequel des diamètres de la pluralité de vis (31) augmentent progressivement d'un côté à l'autre côté opposé de la plaque de recouvrement (2).

5. Boîtier de dispositif électronique selon l'une quelconque des revendications 2 à 4, dans lequel une rondelle est disposée entre un écrou d'au moins l'une parmi la pluralité de vis et la plaque de recouvrement (2), et un diamètre d'une bague extérieure de la rondelle est supérieur à un diamètre de l'écrou de la vis.

6. Boîtier de dispositif électronique selon l'une quelconque des revendications 2 à 4, dans lequel dans la pluralité de vis, une rondelle est disposée entre un écrou de chaque vis et la plaque de recouvrement (2), dans lequel un diamètre d'une bague extérieure de la rondelle est supérieur à un diamètre de l'écrou de la vis, et une zone de contact entre la rondelle d'au moins l'une parmi les vis et la plaque de recouvrement (2) est plus petite qu'un panneau de contact d'une zone de contact entre une rondelle d'une autre vis et la plaque de recouvrement (2).

7. Boîtier de dispositif électronique selon la revendication 6, dans lequel une zone de contact entre la plaque de recouvrement (2) et une pluralité de rondelles augmente progressivement d'un côté à l'autre côté opposé de la plaque de recouvrement (2).

8. Boîtier de dispositif électronique selon la revendication 6, dans lequel au moins trois vis (31) sont disposées de manière séquentielle d'un côté à l'autre côté opposé de la plaque de recouvrement (2), et un diamètre d'une rondelle d'une vis située dans une position médiane dans les trois vis est inférieur au diamètre des rondelles de vis situées sur deux côtés.

9. Boîtier de dispositif électronique selon l'une quelconque des revendications 1 à 8, dans lequel une structure pliable existe entre une fixation ayant la plus petite zone de sertissage avec la plaque de recouvrement (2) et une autre fixation.

10. Boîtier de dispositif électronique selon la revendication 9, dans lequel la structure pliable est une rainure (5) prévue entre la fixation ayant la plus petite zone de sertissage avec la plaque de recouvrement (2) et l'autre fixation.

11. Dispositif électronique, comprenant le dispositif électronique selon l'une quelconque des revendications 1 à 10.
